Europäisches Patentamt

European Patent Office

Office européen des brevets

(19)

(11) **EP 0 875 039 B1**

(12) **FASCICULE DE BREVET EUROPEEN**

(45) Date de publication et mention
de la délivrance du brevet:
**22.08.2001   Bulletin 2001/34**

(21) Numéro de dépôt: **97901116.0**

(22) Date de dépôt: **17.01.1997**

(51) Int Cl.⁷: **G06K 19/077**

(86) Numéro de dépôt international:
**PCT/FR97/00098**

(87) Numéro de publication internationale:
**WO 97/26621 (24.07.1997 Gazette 1997/32)**

(54) **MODULE ELECTRONIQUE SANS CONTACT POUR CARTE OU ETIQUETTE**

KONTAKTLOSES ELEKTRONISCHES MODUL FÜR KARTE ODER ETIKETTE

CONTACTLESS ELECTRONIC MODULE FOR A CARD OR LABEL

(84) Etats contractants désignés:
**AT BE CH DE DK ES FI FR GB IE IT LI LU MC NL
SE**

(30) Priorité: **17.01.1996  FR 9600889**

(43) Date de publication de la demande:
**04.11.1998   Bulletin 1998/45**

(60) Demande divisionnaire:
**01103498.0 / 1 118 960**

(73) Titulaire: **GEMPLUS
13881 Gémenos Cédex (FR)**

(72) Inventeurs:
 • **LEDUC, Michel
   F-13530 Trets (FR)**
 • **MARTIN, Philippe
   F-21200 Beaune (FR)**
 • **KALINOWSKI, Richard
   F-13470 Carnoux-en-Provence (FR)**

(56) Documents cités:
   **EP-A- 0 376 062      EP-A- 0 521 778
   EP-A- 0 620 537      DE-A- 4 311 493
   DE-C- 3 721 822      DE-U- 8 909 783**

**Description**

La présente invention concerne le domaine des objets portatifs tels que notamment les étiquettes électroniques et les cartes à puce sans contact, pourvues d'un module électronique comprenant un microcircuit intégré.

L'invention concerne aussi un procédé de fabrication de tels modules et de tels objets portables.

On connaît déjà des objets portables sous la forme de cartes sans contact, au format ISO, qui sont destinées à la réalisation de diverses opérations, telles que par exemple, des transactions de paiement de prestations de transport, téléphoniques ou autres. Ces opérations s'effectuent grâce à un couplage à distance entre le module électronique de la carte et un appareil récepteur ou lecteur. Le couplage peut être réalisé en mode lecture seule ou en mode lecture/écriture.

En ce qui concerne les cartes, il est à noter que l'invention ne concerne pas uniquement les cartes ayant un fonctionnement exclusivement sans contact. Elle concerne également des cartes mixtes ou hybrides, qui ont la possibilité de fonctionner selon les deux modes: sans contact et par contact. Ces cartes mixtes sont destinées, par exemple, à des opérations du type télébilletique, dans lesquelles, après avoir été chargées en unités de valeur (unités monétaires, unités de paiement de prestations diverses), elle sont débitées à distance d'un certain nombre de ces unités de valeur lorsqu'elles passent au voisinage d'une borne de lecture: ce type de débit suppose un fonctionnement sans contact. Si nécessaire, ces cartes sont rechargées dans un distributeur adapté à cet effet.

Pour les besoins de la présente description, et à titre de simplification, on désignera aussi bien les cartes mixtes que les cartes sans contact, par la même terminologie de cartes sans contact.

On connaît par ailleurs des objets portables sous la forme d'étiquettes électroniques, généralement utilisées pour diverses opérations d'identification ou de suivi. Elles sont composées d'une part d'un module électronique à microcircuit, et d'autre part d'un support de ce module associé à une antenne bobinée fonctionnant à fréquence relativement basse (150 Khz) et de dimensions relativement grandes par rapport à celles du module.

Telles qu'ils sont réalisés actuellement, les objets portables en forme d'étiquettes électroniques comportent des antennes ayant un grand nombre de tours, souvent supérieur à 100, et leurs dimensions rendent leur manipulation délicate, notamment au cours des étapes de fabrication des étiquettes mettant en oeuvre la connexion par soudure de l'antenne au microcircuit du module.

De façon similaire, les objets portables en forme de cartes sans contact présentent également des inconvénients. Telles qu'elles sont réalisées actuellement, les cartes sans contact sont des objets portables de dimensions normalisées. Une norme usuelle mais nullement limitative pour la présente invention est celle dite ISO 7810 qui correspond à une carte de format standard de 85 mm de longueur, de 54 mm de largeur, et de 0,76 mm d'épaisseur.

Dans la plupart des cartes sans contact connues, chaque carte comporte un corps de carte réalisé par un assemblage de feuilles en matière plastique, et noyé dans cet assemblage, un module électronique comprenant un circuit intégré ou microcircuit encore appelé «puce», relié à l'aide de deux bornes de connexion, à une antenne bobinée du type self inductance. La puce comporte une mémoire, et peut dans certains cas comporter un microprocesseur. Les dimensions du module électronique sont sensiblement inférieures aux dimensions de la carte, le module étant en général positionné dans l'un des coins de la carte, puisque les contraintes mécaniques imposées au module du fait des flexions de la carte y sont moins élevées qu'au centre de la carte.

Dans certaines cartes sans contact connues cependant, un corps de carte pourvu d'une cavité est prévu, et un module pourvu d'une bobine connectée à un circuit intégré est prévu, pour assurer un fonctionnement sans contact de la carte.

Dans cette catégorie de cartes sans contact, on connait en particulier, d'après le DE-A-43 11 493 (AMATECH), une unité d'assemblage pour la fabrication d'unités d'identification au format carte. Ce document reflète le préambule de la revendication 1.

Selon un premier mode de réalisation, un module 21 comporte un support de module 28 sur lequel est fixée une puce de circuit intégré 29. Une bobine 30 surmonte la puce 29, de façon à donner au module une capacité d'identification sans contact. Ce document précise que la distance de lecture entre le module et le lecteur sans contact est faible. En outre, aucune carte à puce utilisant un tel module avec antenne n'a apparemment encore été commercialisée, compte tenu des problèmes de coût et de faible portée qui se posent nécessairement avec la structure de module décrite.

En outre, il est à noter que dans ce document, l'antenne se présente sous la forme d'une antenne à air bobinée, rapportée au-dessus de la puce, ce qui présente des difficultés de réalisation, de coût, de rendement, et de manque d'homogénéité des performances.

On connaît également, d'après le DE-C-37 21 822 (PHILIPS), une carte à puce à fonctionnement sans contact, dont la conception est destinée à résoudre un problème de mauvaise connexion entre la bobine et le circuit intégré. A cet effet, ce document décrit une carte à puce sans module, une antenne 4 étant réalisée à même le semiconducteur sur lequel est réalisé le circuit intégré 5. En effet, l'antenne est réalisée en même temps que les pistes supérieures du circuit intégré, de sorte qu'il en résulte un circuit intégré de 4 x 6 à 6 x 8 mm$^2$, portant 20 petites spires.

Il en résulte que la surface utile de l'antenne est très faible, ce qui nuit à la portée. En outre, la carte selon ce document ne peut pas être fabriquée de façon très économique. En effet, on sait que la taille d'une pastille semiconductrice élémentaire est un des principaux facteurs de coût d'un circuit intégré produit en grandes quantités. Or dans ce document, la taille minimale du circuit intégré incorporant l'antenne est de l'ordre de 24 mm$^2$ au minimum, alors que les cartes sans contact bon marché utilisent en général des microcircuits dont la taille est très petite, de l'ordre de 1 mm$^2$.

Le document DE-A- 43 11 493 décrit notamment un module électronique approprié pour être inséré dans une carte sans contact, et comportant un support destiné à recevoir sur un même côté une antenne plane connecté à un microcircuit; ledit microcircuit étant par ailleurs disposé en position centrale par rapport à ladite antenne.

Le document EP-A-0 620 537 divulgue une étiquette électronique dans laquelle l'antenne est constituée par une bobine à air relativement volumineuse, puisque constituée là encore d'un bobinage sans noyau consistant en une pluralité de spires disposées sur plusieurs couches.

Le document EP-A- 0 376 062 décrit quant à lui un module électronique dont le support comporte, sur un même côté, un microcircuit disposé au centre d'une antenne également de type bobine à air, c'est-à-dire formée d'un bobinage de spires sur plusieurs couches.

On connaît encore une pluralité d'autres procédés de réalisation de cartes sans contact, tels que ceux décrits dans les demandes de brevet français de la même demanderesse, publiées sous les numéros FR-A-2 716 281, FR-A-2 716 555 et FR-A-2 721 733. Ces demandes de brevet ont en commun de décrire une carte sans contact pourvue d'une antenne sensiblement de la taille de la carte, connectée à un micromodule portant la puce.

Une telle antenne présente l'avantage d'une portée relativement élevée pour un champ magnétique de lecture ou d'écriture donné. En effet, la relation qui lie la force électromotrice E apparaissant aux bornes de l'antenne de réception lorsqu'elle coupe un champ électromagnétique est du type suivant:

$$(1) \qquad E_r = L_e.(K_e.S_e.N_e).(K_r.S_r.N_r)/D^3$$

où K est une constante, S désigne la surface d'une spire moyenne d'antenne, N désigne le nombre de spires qui sont enroulées pour former l'antenne, les indices e et r représentant respectivement les côtés émission et réception, et D désigne la distance de lecture, c'est-à-dire la distance entre l'antenne de la carte, et l'antenne du lecteur extérieur.

Or, afin de faire fonctionner les circuits de la puce de la carte pour initialiser et effectuer une opération de lecture, la tension $E_r$ doit dépasser un certain seuil, qui est en général de l'ordre de 3 Volts.

On voit donc que pour une distance de lecture ou d'écriture D donnée que l'on cherche à atteindre avec la carte sans contact, il faut augmenter la surface de la spire moyenne et/ou le nombre N de spires de l'antenne, du côté lecture et/ou écriture.

L'efficacité de l'antenne sera conditionnée, à la fréquence retenue pour la lecture ou l'écriture, par le coefficient de surtension de la bobine d'antenne, qui est donné par l'expression:

$$(2) \qquad Q=L\omega/R$$

où L est l'inductance de la bobine, qui augmente avec le diamètre de la bobine et le nombre de tours, $\omega = 2\pi f$ où f désigne la fréquence de lecture, qui est figée pour une application donnée, et R désigne la résistance électrique de la bobine d'antenne, qui est proportionnelle à la longueur du fil qui la constitue.

Les grandeurs L et R ayant des influences contraires sur l'efficacité de l'antenne, elles ont tendance à se compenser, de sorte que le véritable facteur d'efficacité de l'antenne est surtout lié à la surface totale S.N de l'antenne.

Or pour une dimension de bobine planaire donnée, le nombre N de spires est limité par la largeur d'une spire et par l'intervalle entre deux spires, qui dépendent de la technologie de réalisation.

On voit donc que, toutes choses étant égales par ailleurs, la tendance naturelle pour obtenir une bonne antenne pour carte sans contact, et qui a été largement utilisée dans la pratique, consiste à utiliser sur la carte sans contact une antenne dont la taille de chaque spire se rapproche autant que possible de la surface de la carte. C'est pourquoi les cartes sans contact commercialisées comportent une antenne intégrée dans le corps de carte, au voisinage de la périphérie de celui-ci.

Mais, comme l'expérience de la fabrication de telles cartes sans contact l'a montré, ce choix entraîne également un certain nombre d'inconvénients.

En effet, la manipulation d'une antenne de cette taille en vue de son intégration dans la carte et de son raccordement électrique au module électronique pose de sérieux problèmes techniques (comme d'ailleurs dans le cas précité des étiquettes électroniques).

En effet, malgré les techniques utilisées, l'assemblage de la carte et de l'antenne reste souvent complexe et coûteux, puisqu'il faut raccorder le module électronique et la bobine d'antenne avec des moyens difficiles à automatiser. Ensuite, l'assemblage subit une lamination, qui est un procédé coûteux nécessitant l'adjonction de résine pour pouvoir noyer la bobine et le module dans la carte de telle manière qu'ils n'apparaissent pas à la surface de la carte et ne défonnent pas les feuilles supérieures et inférieures utilisées pour la colamination.

En outre, la complexité du procédé ne permet pas l'obtention de rendements comparables à ceux obtenus lors de la fabrication des cartes à contact. Ceci est d'autant plus vrai lorsqu'on intègre les contraintes requises par certains types d'impression de la carte, et par la présence éventuelle d'une piste magnétique ou d'un embossage. En effet, pour certains types d'impression de la carte, ou pour la réalisation d'une bande magnétique sur la carte, celle-ci doit présenter une planéité quasi-parfaite, avec des défauts inférieurs à 6 μm. En cas d'embossage, il faut choisir des matériaux compatibles avec le procédé de fabrication de la carte, et l'antenne doit notamment laisser libre la zone prévue pour l'embossage, faute de quoi elle serait abîmée lors de l'embossage.

Compte tenu de l'ensemble des inconvénients liés aux modes actuels de fabrication de cartes sans contact et d'étiquettes électroniques, qui se traduisent principalement par un coût de fabrication élevé, les ingénieurs de la demanderesse se sont donnés pour objectif de proposer des procédés nouveaux de fabrication de cartes et d'étiquettes sans contact, susceptibles d'éviter l'ensemble des inconvénients cités.

Plus précisément, le but de la présente invention est de proposer des moyens peu coûteux aptes à être utilisés lors de la fabrication d'objets portables du type cartes à puce et/ou d'étiquettes électroniques.

Un autre but de l'invention est de fournir un procédé de fabrication d'étiquettes sans contact, de faible coût, permettant une fabrication fiable et de qualité à l'aide de machines automatisées.

A cet effet, l'invention propose un module électronique tel que défini dans la revendication 1.

Ainsi, l'invention fournit un élément de base de faibles dimensions, apte à être utilisé pratiquement indifféremment lors de la fabrication de cartes sans contact au format usuel, ou d'étiquettes électroniques de faibles dimensions, quelle que soit leur forme.

Selon d'autres caractéristiques avantageuses du module électronique selon l'invention:

-    l'antenne est constituée par une spirale de dimensions extérieures de l'ordre de 5 à 15 mm, de préférence de l'ordre de 12 mm, dont les extrémités sont reliées à des plots de contact du microcircuit électronique.
-    l'antenne est constituée par une spirale conductrice comportant entre 6 et 50 spires, chaque spire possèdant une largeur de l'ordre de 50 à 300 μm, l'espacement entre deux spires contiguës étant de l'ordre de 50 à 200 μm.
-    la spirale formant l'antenne est par exemple de forme extérieure sensiblement circulaire, de diamètre extérieur de l'ordre de 5 à 15 mm et de préférence d'environ 12 mm. En variantes, ladite spirale est de forme extérieure sensiblement carrée, de côté extérieur de l'ordre de 5 à 15 mm, et de préférence d'environ 12 mm, ou de forme extérieure sensiblement ovale, présentant une plus grande dimension de l'ordre de 15 mm, et une plus petite dimension de l'ordre de 5 mm.

-    le module électronique comporte sur une face du substrat de support une antenne connectée au microcircuit, et sur l'autre face du substrat de support, des plots de contacts apparents et également connectés au microcircuit, de façon à obtenir une carte hybride pouvant être lue et écrite par l'intermédiaire des contacts et/ou de l'antenne.
-    un condensateur d'accord est connecté en parallèle aux bornes de l'antenne et du microcircuit électronique, et sa valeur est choisie pour obtenir une fréquence de fonctionnement du module située dans une plage de l'ordre de 1 Mhz à 450 Mhz. En particulier, le condensateur d'accord à une valeur de l'ordre de 12 à 180 picoFarad, et la fréquence de fonctionnement du module est d'environ 13,56 Mhz. En variante, le condensateur d'accord à une valeur de l'ordre de 30 à 500 picoFarad, et la fréquence de fonctionnement du module est d'environ 8,2 Mhz. Ce condensateur d'accord est obtenu par dépôt de silicium oxydé sur la surface du microcircuit, préalablement revêtu d'un isolant.

L'invention concerne également une étiquette électronique comportant un module électronique de faibles dimensions à antenne intégrée, notamment du type décrit ci-dessus, ainsi qu'un procédé de fabrication d'une étiquette électronique de ce type.

Pour fabriquer une étiquette électronique, l'invention prévoit d'utiliser les chaînes de fabrication de cartes sans contact. A cet effet, il suffit de découper un module électronique à partir d'une carte sans contact de telle manière à laisser subsister autour du module électronique un peu de matière du corps de carte, à des fins de protection du module. Cette technique peut être complétée par la découpe d'une autre pièce de même forme, par exemple à partir de la même carte, puis à fixer cette pièce contre la première de manière à entourer et protéger le module.

L'invention sera mieux comprise en se référant à la description suivante faite à titre d'exemple non limitatif et aux dessins ci-annexés, dans lesquels:

-    la figure 1 représente une carte sans contact selon l'état de la technique;
-    la figure 2 représente une carte sans contact selon l'invention;
-    la figure 3 représente une bande utilisée pour la fabrication en continu de modules électroniques selon l'invention, destinés à des cartes sans contact ou à des étiquettes électroniques selon l'invention, ainsi qu'une carte destinée à recevoir le module;
-    les figures 4A à 4G représentent plusieurs variantes de réalisation d'un module électronique selon l'invention, apte ou destiné à être incorporé dans le corps d'une carte sans contact ou dans une étiquette électronique;
-    les figures 5A à 5D représentent en vue en coupe plusieurs variantes de réalisation d'un module électronique pourvu d'une antenne, selon l'invention;

- la figure 6 représente en coupe un module pour carte hybride à contact et sans contact.
- la figure 7 représente les étapes d'un procédé de fabrication d'une variante d'étiquette électronique utilisant le module électronique selon l'invention.

Des éléments similaires sont désignés par les mêmes numéros de référence dans l'ensemble des figures.

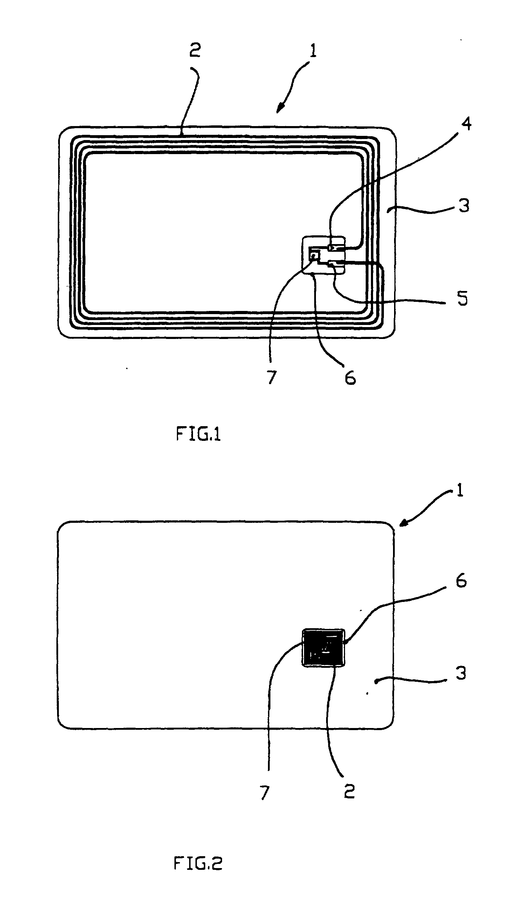

On se réfère à la figure 1 montrant de façon schématique et en plan une carte sans contact 1 du type de celles effectivement commercialisées. Comme on le voit, une antenne 2 sous la forme d'une bobine de grande dimension, légèrement inférieure à la dimension de la carte, est intégrée dans le corps de carte 3, et deux extrémités de la bobine d'antenne 2 sont connectées à des contacts d'alimentation 4,5 d'un module électronique 6 portant un microcircuit intégré 7 encore appelé une puce.

La bobine est représentée à l'échelle, sauf en ce qui concerne le nombre de spires, seules quatre spires ayant été représentées. Pour assembler une telle bobine 2 avec le corps de carte 3, il est nécessaire d'effectuer des opérations de laminage ou d'injection complexes et coûteuses, avec les inconvénients mentionnés précédemment. Une telle antenne permet de lire les informations de la carte, à partir d'une distance de 70 mm, pour une fréquence utilisée de quelques Mhz.

A la différence de la carte de la figure 1, le principe général sous-jacent à l'invention consiste à éliminer les antennes de grande taille actuellement utilisées pour les cartes sans contact, afin de supprimer les inconvénients mentionnés plus haut L'invention cherche également à utiliser, pour atteindre les objectifs de fiabilité et de faible coût de fabrication visés, certains principes et les chaînes de fabrication utilisés lors de la fabrication de cartes à contact, cette fabrication étant maintenant bien maîtrisée et permettant d'obtenir des coûts de fabrication faibles.

La solution proposée est représentée de façon schématique sur la carte 1 de la figure 2. Elle consiste à utiliser un module particulier 6 de carte à puce combinant sur un même support de faibles dimensions, les fonctions électroniques des modules classiques à puce, et la fonction d'antenne d'émission/réception pour la transmission sans contact d'informations entre la carte et un dispositif de lecture/écriture extérieur (non représenté).

Le module 6 présente des dimensions compatibles avec les procédés de réalisation connus et utilisés pour fabriquer les cartes à contact, à la fois dans le sens de l'épaisseur et en plan, dans le sens de la longueur et de la largeur du module.

Bien entendu, pour qu'un module pourvu d'une antenne soit réalisable, il faut que, à l'inverse des enseignements de l'état de la technique, l'antenne soit obtenue avec des dimensions compatibles avec celles du module, tout en conservant un nombre de spires assurant la possibilité d'une transmission électromagnétique à une distance suffisante, de l'ordre de quelques centimètres. A cet effet, l'antenne est réalisée sous la forme d'une spirale formée d'un ensemble de spires situées directement sur le substrat de support et sensiblement dans le même plan, ce qui exclut les bobines à air enseignées par certains documents de l'état de la technique cité plus haut.

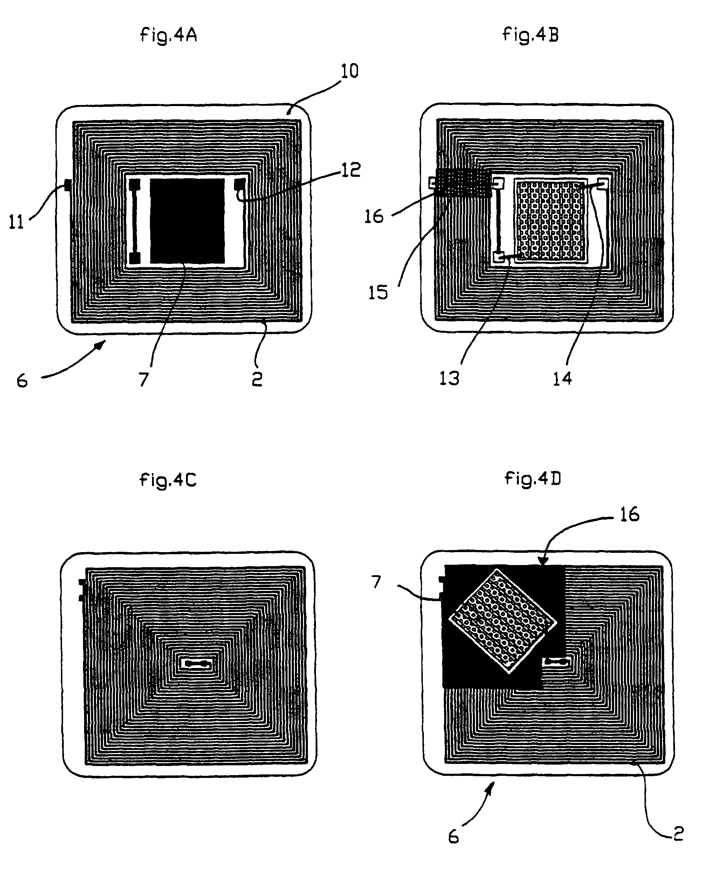

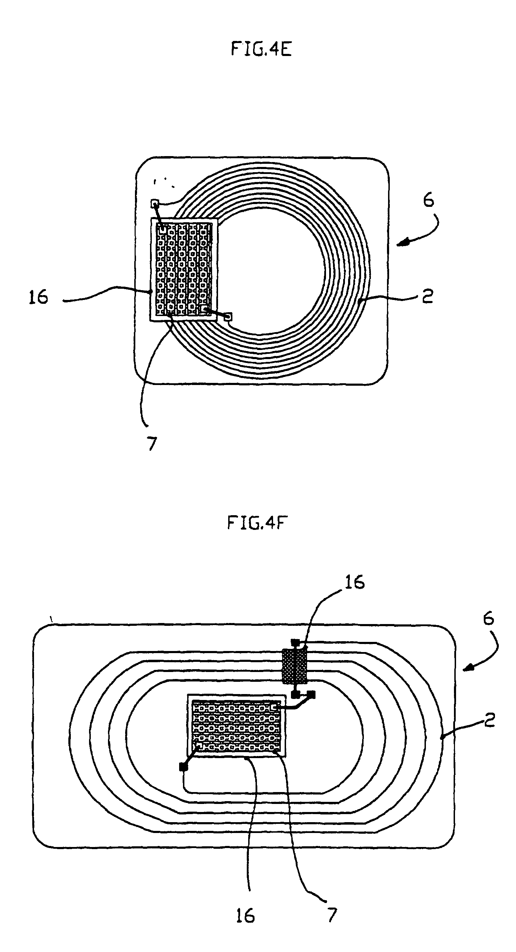

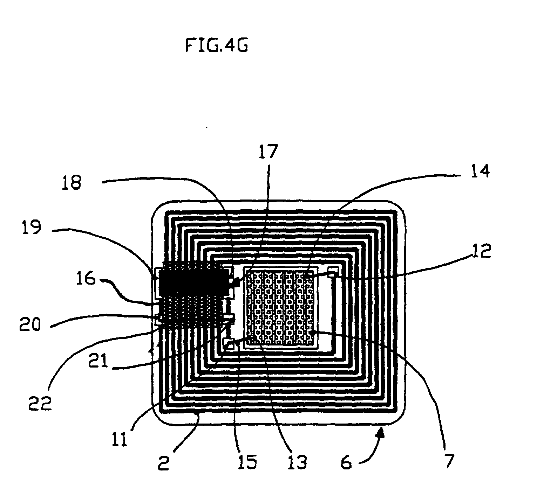

Afin de s'adapter au mieux à la forme du module et à la surface disponible, l'antenne peut avoir une spire extérieure de forme sensiblement carrée, rectangulaire, circulaire ou ovale, ou toute autre forme appropriée. Les deux extrémités de l'antenne sont connectées à des bornes d'alimentation d'un circuit intégré, notamment une mémoire et/ou un microprocesseur, situé(e) également sur le module, comme schématisé en 7 sur la figure 2, mais représenté plus en détail dans les figures 4 à 6.

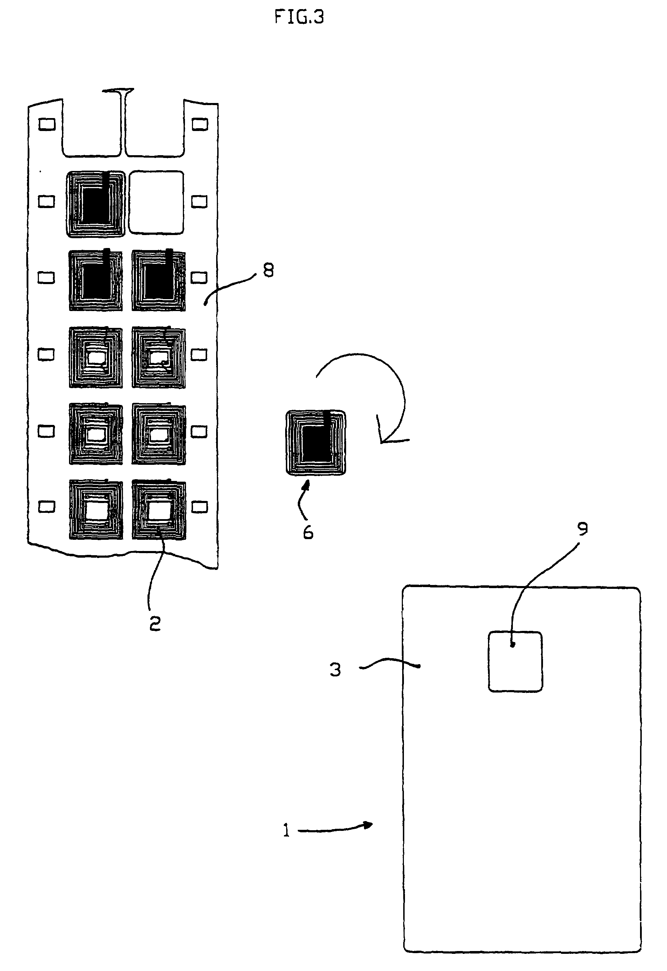

On se réfère à la figure 3 illustrant la séparation d'un module électronique 6 selon l'invention, à partir d'une bande 8 comportant une pluralité de modules 6 disposés par exemple selon deux rangées. La fabrication de modules électroniques classiques sur de telles bandes est bien connue en elle-même dans le domaine de la fabrication de cartes à contact, et ne sera de ce fait pas décrite davantage.

Un module 6 selon l'invention, par exemple du type comportant un circuit intégré 7 « à cheval » sur les spires d'une antenne 2 en forme de spirale carrée, est détaché de la bande 8 par un procédé de découpe, par exemple une découpe mécanique. Le module découpé est prélevé par des moyens automatiques non représentés mais connus, et amené, de préférence à l'envers (circuit intégré et antenne tournés vers le fond de l'ouverture du corps de carte) en face d'une ouverture borgne 9 aménagée dans le corps de carte 3 d'une carte à puce 1 sans contact. La fixation du module 6 dans l'ouverture 9 prévue est faite par collage, soudure, ou tout autre moyen approprié.

Il en résulte une carte sans contact conforme à l'invention, pourvue d'une antenne 2 localisée au niveau du module électronique 6, et dont la fabrication se réduit principalement aux étapes qui viennent d'êtres décrites, suivies bien entendu le cas échéant d'étapes d'impression et de personnalisation classiques.

Les figures 4A à 4G représentent de manière plus détaillée plusieurs variantes de modules destinés à être encartés pour fabriquer des cartes sans contact, ou encore intégrés dans un support de forme différente de la carte, par exemple pour fabriquer des étiquettes électroniques.

Un module 6 est composé d'un substrat de support 10 traditionnel (en film relativement flexible, en mylar, epoxy ou capton ) sur lequel est reporté, non pas une bobine, mais un motif d'antenne 2, qui peut être réalisé de plusieurs manières, comme expliqué plus loin. L'antenne 2 est par exemple réalisée par emboutissage à partir d'une feuille en cuivre, suivi d'un assemblage de la feuille emboutie avec le substrat de support. Le substrat de support 10 et l'antenne 2 sont le cas échéant assemblés de manière précise, en utilisant les moyens d'entraînement et de positionnement connus du substrat.

L'antenne 2 peut aussi être obtenue par gravure photochimique du motif d'antenne, ou par dépôt de matière métallique sur un film flexible formant le substrat 10. Le choix du substrat de support 10 approprié a des conséquences sur l'épaisseur du module, et dépend principalement de l'utilisation visée pour le module. Ce choix est entièrement à la portée de l'homme de métier.

Dans une variante proposée pour le module électronique 6, l'antenne 2 est constituée par une piste de cuivre de l'ordre de 15 μm à 70 μm d'épaisseur, réalisée en spirale, avec une distance entre spires de même grandeur. Les extrémités 11,12 de cette spirale sont de préférence élargies de façon à constituer des plots de contact pour la liaison avec le microcircuit 7.

Plusieurs variantes de positionnement respectif du microcircuit et de l'antenne sont prévus. Dans un premier mode de réalisation pratique et peu encombrant du module 6 (figure 4A), la puce 7 est collée au centre de l'antenne 2. En figure 4B, on a également représenté des fils conducteurs de liaison 13,14 pour relier une borne respective de la puce 7 à une extrémité respective correspondante 11,12 de l'antenne. Pour ce faire, il est nécessaire de passer un fil 15 au-dessus des pistes de l'antenne. A cet effet, un isolant 16 est au préalable déposé, notamment par sérigraphie, entre la zone correspondante des pistes, et le fil de liaison 15.

Dans un autre mode de réalisation du module 6 (figure 4C), l'antenne 2 occupe tout un côté du module et est dépourvue d'espace libre en son centre. Dans ce cas, l'invention prévoit de coller le microcircuit 7 soit sur la face du module dépourvue d'antenne, soit sur la même face que l'antenne (figure 4D), après interposition d'un isolant (partie sombre 16) entre l'antenne 2 et le microcircuit 7.

En figure 4E est représentée une variante de module électronique 6, dans laquelle l'antenne 2 a la forme d'une spirale circulaire, le microcircuit 7 étant positionné au-dessus du plan des spires, avec interposition d'un isolant 16. Cette configuration permet de minimiser la longueur des fils de connexion entre l'antenne et le microcircuit.

En figure 4F est représentée une variante supplémentaire du module 6 selon l'invention, particulièrement adaptée dans les cas où un module oblong ou rectangulaire est nécessaire. Dans ce cas, le motif d'antenne 2 a une forme de spirale sensiblement oblongue, le microcircuit 7 est de préférence positionné au centre de l'antenne, et des connexions entre les bornes du microcircuit et les plots de la bobine sont réalisés comme décrit en liaison avec la figure 4B.

Il est à noter que la connexion entre les plots de la puce et les bornes de contact de l'antenne peut être réalisée en utilisant une technique conventionnelle de connexion de fils conducteurs, comme par exemple la liaison dite par « bonding » consistant en des fils conducteurs soudés entre un plot du microcircuit et une borne respective de l'antenne, ou encore en utilisant la technique dite de « flip-chip » consistant à reporter le microcircuit sur le substrat de module 10, en ayant la face portant l'antenne et le microcircuit collée sur le substrat. La protection par résine des contacts est ensuite effectuée en utilisant les procédés traditionnels de réalisation des cartes à puce à contacts.

La figure 4G représente en vue plus détaillée un module électronique 6 selon l'invention, sur lequel un condensateur d'accord 17 a été réalisé à cheval sur les spires d'antenne, par dépôt au-dessus d'une couche d'isolant 16 (partie grisée). Afin de connecter le condensateur en parallèle entre les bornes 11,12 de l'antenne 2 et les plots 13,14 du microcircuit, une borne 18 du condensateur 17 est reliée à la borne 12 et au plot 14, et l'autre borne 19 du condensateur 17 est reliée à la borne 11 et au plot 13, par l'intermédiaire de plots intermédiaires 20,21 reliés par une connexion intermédiaire 22 située entre les plots intermédiaires 20,21 et réalisée au-dessus de la couche isolante 16, de façon à ne pas court-circuiter les spires de l'antenne.

Bien entendu, d'autres dispositions du condensateur d'accord 17 sont possibles. Il sera en particulier possible de l'intégrer sur le microcircuit 7 lui-même, au stade de conception de celui-ci, ce qui économisera des étapes de fabrication du module 6.

Le motif d'antenne est déterminé pour permettre un fonctionnement à haute fréquence, de l'ordre du Mhz, la valeur du condensateur d'accord 17 étant choisie pour obtenir une fréquence déterminée de fonctionnement de l'antenne 2 située dans une plage de hautes fréquences de l'ordre de 1 Mhz à 450 Mhz. Dans un exemple de réalisation permettant d'obtenir une fréquence de fonctionnement usuelle d'environ 13,56 Mhz, le condensateur d'accord 17 a une valeur de l'ordre de 12 à 180 picoFarad. Dans une autre variante permettant un fonctionnement à 8,2 Mhz, le condensateur d'accord à une valeur de l'ordre de 30 à 500 picoFarad.

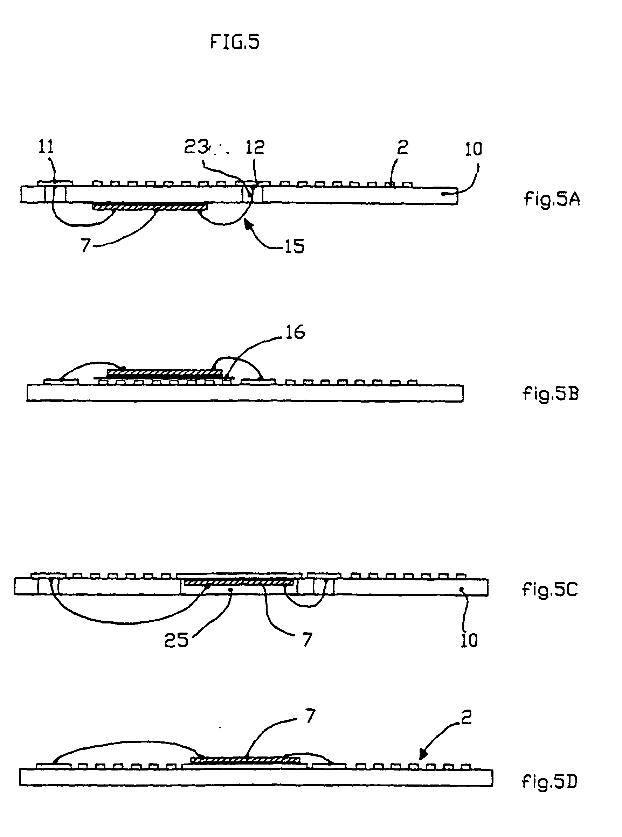

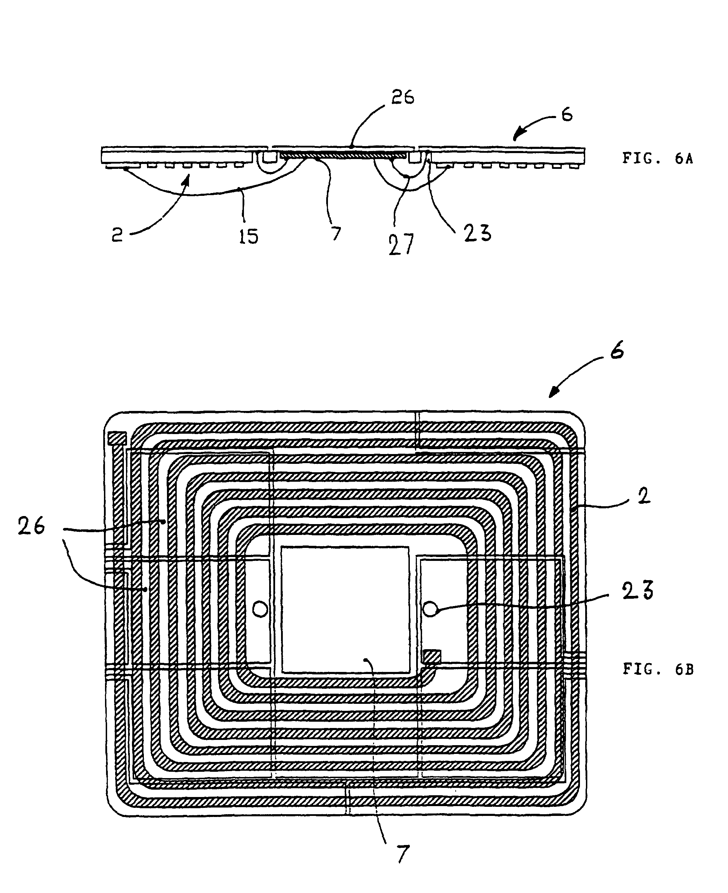

Les figures 5 et 6 montrent divers modes de réalisation du module 6, représenté en coupe. En figure 5, on a utilisé comme antenne une grille métallique découpée puis collée sur un substrat de support 10. Le découpage mécanique d'une antenne spiralée convient pour des largeurs de pistes pas trop fines, de l'ordre de 300 μm au minimum à l'heure actuelle.

En figure 5A, le microcircuit 7 et l'antenne 2 sont situés sur les deux faces opposées du substrat de support 10 du module, les bornes de contact 11,12 de l'antenne 2 étant connectés à des plots du microcircuit (non représentés) par l'intermédiaire de fils de connexion 15 amenés à travers des puits 23 réalisés dans le support 10.

En figure 5B, le microcircuit 7 est du même côté que l'antenne 2, et disposé au-dessus de ses spires avec interposition d'un isolant 16. En figure 5C, le microcircuit 7 est disposé dans une cavité 25 aménagée à cet effet dans le support 10 du module, ce qui permet de diminuer l'épaisseur de l'ensemble du module 6. En figure 5D, le microcircuit 7 est simplement collé au centre de l'antenne 2, comme montré également en figures 4A,4B. Dans tous les cas, l'antenne est entièrement située sur le substrat de support 10 faisant partie du module, et le microcircuit est rapporté sur cette structure de substrat et d'antenne.

Il est à noter que pour réduire encore l'épaisseur du module 6, il est possible d'utiliser pour l'antenne 2 une grille gravée dans ou déposée par métallisation ou autrement sur un substrat de support 10 approprié, au lieu d'une grille métallique découpée.

On se réfère maintenant à la figure 6, dans laquelle a été représentée en coupe et en vue de dessus une autre forme de réalisation du module électronique 6, afin d'obtenir un module hybride à contact et sans contact, particulièrement adapté à la fabrication de cartes hybrides. Dans ce module, le microcircuit 7 et l'antenne sont disposés sur une première face du substrat de support 10 du module, comme déjà décrit en liaison avec la figure 5. En outre, des contacts 26 usuels identiques aux contacts des cartes à contact sont connectés à des plots correspondants du microcircuit par des fils conducteurs 27. Le microcircuit dialoguera avec l'extérieur en utilisant les contacts 26 ou l'antenne 2, en fonction du signal extérieur appliqué. L'ensemble des composants utiles pour le fonctionnement de la carte hybride, y compris l'antenne 2, est donc disposé sur un module hybride 6 de faibles dimensions, apte à être encarté, c'est-à-dire incorporé dans un corps de carte.

De façon avantageuse, deux modules 6 de l'un des types décrits plus haut pourront être réalisés côte à côte dans la largeur d'un film 10 standard (soit 35 mm), mais d'autres arrangements des modules 6 sur une bande de support 8 sont compris dans le cadre de l'invention. Chaque module 6 pourra être ensuite reporté sur un corps de carte 3 au format ISO standard en utilisant le procédé traditionnel de report des modules dans les corps de cartes, tel qu'utilisé pour la fabrication de cartes à contacts.

Alternativement, les modules 6 peuvent être utilisés pour la fabrication d'étiquettes électroniques, du type de celles utilisées pour l'identification d'objets. Si nécessaire, après leur découpe à partir de la bande de support 8, les modules 6 seront protégés par un revêtement protecteur en résine ou tout autre matériau approprié, ce qui permettra d'obtenir à faible coût des étiquettes de petites dimensions. Bien entendu, les modules peuvent également être intégrés à ou fixés sur des supports différents ou plus volumineux (clés, emballages, etc...), en fonction de l'application visée.

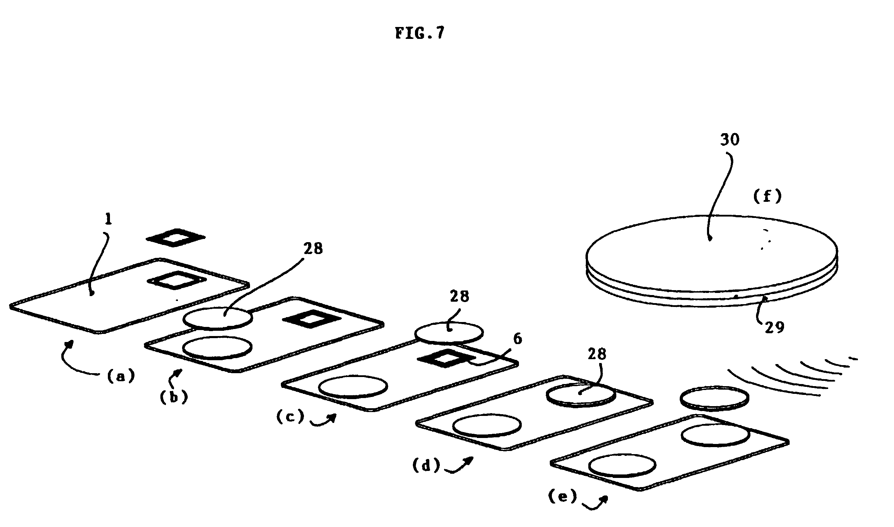

On se réfère à la figure 7. En variante intéressante du procédé de fabrication d'étiquettes, afin de profiter des économies d'échelle et des lignes de fabrication de cartes sans contact tout en utilisant des modules 6 selon l'invention, il est également possible de fabriquer des étiquettes électroniques selon un procédé comprenant uniquement l'étape consistant à découper un module électronique 6 tel que décrit plus haut, à partir d'une carte sans contact 1 incorporant un tel module, de façon à laisser subsister autour du module électronique 6 un peu de matière du corps de carte, à des fins de protection du module 6. Ainsi, on obtient très facilement à partir de cartes sans contact selon l'invention, fabriquées en grand nombre, des étiquettes électroniques présentant l'épaisseur d'une carte, mais de dimensions en plan beaucoup plus faibles.

Il apparait cependant dans ce cas un inconvénient qui peut être majeur dans certaines applications: en procédant par simple découpage à partir d'une carte sans contact, l'étiquette n'est protégée d'un côté que par la protection très minime procurée sur un côté de la cavité de la carte par un voile de matière plastique d'une centaine de micromètres d'épaisseur, alors que l'autre face du module est exposée. Pour remédier à cet inconvénient, il est possible de manière judicieuse de découper dans une partie de la carte 1 représentée en Figure 7(a), qui serait de toute manière jetée, une première pièce 28 au format prévu pour l'étiquette. Puis comme représenté dans la figure 7(b), on reporte cette pièce 28 sur la face de l'étiquette montrant le module 6 apparent et non protégé. La pièce 28 est assemblée sur la carte 1 comme représnté en figure 7(d), par une technique quelconque appropriée, notamment le collage ou la soudure par ultrasons. Enfin, comme représenté en figure 7(e), on découpe à nouveau dans la carte une pièce 29 au format de la pièce 28 et au niveau de celle-ci. On obtient ainsi pour un coût minimal, une étiqutte électronique 30 symétrique représentée agrandie en figure 7(f). Bien entendu, on pourrait aussi découper les pièces 28, 29 séparément pour les assembler par la suite.

Cette étiquette 30 incorpore un module 6 protégé des deux côtés, et est susceptible d'être personalisée graphiquement des deux côtés pour en faire des étiquettes utilisables dans des jeux ou toutes autres applications.

En ce qui concerne les performances des modules, cartes et étiquettes selon l'invention, les résultats théoriques et pratiques montrent que l'on obtient sur le module 6 une antenne performante pouvant fonctionner dans la gamme de fréquences de 1 à 450 Mhz.

Pour obtenir les performances de liaison recherchées pour une application donnée, il suffit d'utiliser une fréquence de modulation suffisamment élevée (13,56 Mhz par exemple) pour obtenir des performances acceptables en distance de lecture/écriture.

Si l'on considère par exemple la fréquence de 13,56 Mhz couramment utilisée dans les applications télébilletiques, les performances obtenues sont tout à fait remarquables. Une puce 7 montée par ce procédé permet d'obtenir actuellement avec l'antenne 2 associée, une distance de fonctionnement de l'ordre de 50 mm là où la même puce montée avec une bobine classique aux dimensions d'une carte permet d'atteindre environ 70 à 75 mm. Cette différence n'est pas critique dans la plupart des applications sans contact visées à l'heure actuelle. De plus, ces performances pourront être sensiblement améliorées en travaillant au niveau des circuits d'émission et de récupération d'énergie électromagnétique du module et des lecteurs externes.

Selon un exemple de réalisation pratique, les dimensions du module utilisé sont de l'ordre de 12 mm x 12 mm, mais on peut envisager des formats oblongs légèrement plus grands pour augmenter les performances, ou encore une optimisation de l'antenne du lecteur ou de la puce elle-même en ce qui concerne sa consommation, pour améliorer les performances et atteindre celles d'une antenne de plus grande taille .

Grâce au concept de l'invention, en cas d'utilisation du module 6 pour fabriquer des cartes, l'intégrité du corps de carte est conservée pendant tout le processus de fabrication. Le corps de carte peut donc aisément être utilisé de manière traditionnelle pour recevoir une piste magnétique. De plus, il pourra être imprimé par tous les procédés existants sans contraintes particulières, autres que celles connues pour la fabrication d'une carte à contact classique.

De même, le choix du matériau du corps de carte est tout à fait libre: il permettra donc de s'adapter aux besoins requis par les diverses applications envisagées.

En conséquence, l'invention permet de résoudre d'un trait tous les inconvénients précités liés à la fabrication de modules sans contact pour cartes sans contact, et notamment celui du coût, de l'encombrement, de l'impression, de la compatibilité avec l'embossage ou la réalisation d'une piste magnétique. Les faibles dimensions de l'antenne induisent des avantages comparables en cas de fabrication d'étiquettes électroniques qui ne sont pas tributaires de la forme d'un corps de carte.

L'intérêt économique de l'invention est incontestable: elle permet de réaliser sur les mêmes chaînes de fabrication, des modules électroniques à antenne intégrée, des étiquettes électroniques et des cartes sans contact fonctionnelles, à une fraction du coût actuel constaté dans les procédés utilisés pour la production de cartes ou d'étiquettes sans contact, et ceci à toutes les étapes de fabrication.

D'autres avantages annexes liés au module, à l'étiquette électronique et à la carte sans contact selon l'invention et à leurs procédés de fabrication résident dans le fait qu'il n'y a pas de manipulation de bobine d'antenne, ni de soudure à l'étain, de positionnement précis de la bobine, ou d'impression avant encartage.

## Revendications

1. Module électronique (6), du type approprié pour la fabrication d'objets portatifs tels que des cartes (1) sans contact et/ou des étiquettes électroniques sans contact, et comportant un substrat de support (10) destiné à recevoir un microcircuit électronique (7), ledit microcircuit électronique (7) étant destiné à être connecté à une antenne (2) de façon à permettre un fonctionnement sans contact du module (6), l'antenne (2) étant tout entière contenue sur le module et comportant des spires réalisées sur le plan du substrat de support (10), le microcircuit (7) étant disposé du même côté que l'antenne (2), caractérisé en ce que le microcircuit (7) est disposé à cheval sur les spires de l'antenne (2), les bornes de connexion (11,12) de l'antenne étant reliées à des plots de contact (13,14) correspondants respectifs du module (6) ou du microcircuit électronique (7) par l'intermédiaire de fils conducteurs (15), et un isolant (16) étant interposé entre le microcircuit (7) et au moins la zone de l'antenne sous le microcircuit.

2. Module électronique (6) selon la revendication 1, caractérisé en ce que ladite antenne (2) est constituée par une spirale de dimensions extérieures de l'ordre de 5 à 15 mm, de préférence de l'ordre de 12 mm, dont les bornes d'extrémités (11,12) sont reliées à des plots de contact (13,14) du microcircuit électronique (7).

3. Module électronique (6) selon la revendication 2, caractérisée en ce que l'antenne (2) est constituée par une spirale conductrice comportant entre environ 6 et environ 50 spires, chaque spire possédant une largeur de l'ordre de 50 à 300 μm, l'espacement entre deux spires contiguës étant de l'ordre de 50 à 200 μm.

4. Module électronique (6) selon la revendication 3, caractérisé en ce que ladite spirale est de forme extérieure sensiblement circulaire, de diamètre extérieur de l'ordre de 5 à 15 mm et de préférence d'environ 12 mm.

5. Module électronique (6) selon la revendication 3, caractérisé en ce que ladite spirale est de forme extérieure sensiblement carrée, de côté extérieur de l'ordre de 5 à 15 mm, et de préférence d'environ 12 mm.

6. Module électronique (6) selon la revendication 3, caractérisé en ce que ladite spirale est de forme extérieure sensiblement ovale, présentant une plus grande dimension de l'ordre de 15 mm, et une plus petite dimension de l'ordre de 5 mm.

7. Module électronique (6) selon l'une quelconque des revendications précédentes, caractérisé en ce qu'un condensateur d'accord (17) est connecté en parallèle aux bornes (11,12) de l'antenne aux plots de contact (13,14) du microcircuit électronique (7), la valeur du condensateur (17) étant choisie pour obtenir une fréquence de fonctionnement du module (6) située dans une plage de l'ordre de 1 Mhz à 450 Mhz.

8. Module électronique (6) selon la revendication 7, caractérisé en ce que le condensateur d'accord (17) a une valeur de l'ordre de 12 à 180 picoFarad, et en ce que la fréquence de fonctionnement du module est d'environ 13,56 Mhz.

9. Module électronique (6) selon la revendication 7, caractérisée en ce que le condensateur d'accord (17) a une valeur de l'ordre de 30 à 500 picoFarad, et en ce que la fréquence de fonctionnement du module est d'environ 8,2 Mhz.

10. Module électronique (6) selon l'une quelconque des revendications 7 à 9, caractérisée en ce que le condensateur d'accord (17) est obtenu par dépôt de silicium oxydé sur la surface du microcircuit (7), préalablement revêtu d'un isolant (16).

11. Module électronique (6) selon l'une quelconque des revendications précédentes, caractérisé en ce qu'il comporte sur une face du support (10) une antenne (2) connectée au microcircuit (7), et sur l'autre face du support (10), des contacts (26) apparents et également connectés au microcircuit (7), de façon à obtenir une carte hybride pouvant être lue et écrite par l'intermédiaire des contacts (26) et/ou de l'antenne (2).

12. Etiquette électronique, notamment destinée à l'identification d'objets, caractérisée en ce qu'elle est pourvue d'un module électronique (6) selon l'une quelconque des revendications 1 à 11.

13. Etiquette électronique selon la revendication 12, caractérisée en ce que la plus grande dimension du module électronique (6) est de l'ordre de 5 à 15 mm.

14. Etiquette électronique selon l'une des revendications 12 ou 13, caractérisée en ce que le module électronique (6) pourvu de son microcircuit (7) et de son antenne (2) est fixé sur ou intégré à un support, de sorte que l'étiquette peut être rendue solidaire d'un objet à identifier.

15. Procédé de fabrication d'une étiquette électronique, caractérisé en ce qu'il comporte les étapes consistant à:

- découper à partir d'une carte sans contact (1), un premier élément (29) incorporant un module électronique (6) selon l'une quelconque des revendications 1 à 11, selon une forme de découpe donnée de façon à laisser subsister de la matière autour du module;

- découper à partir d'une carte, de préférence de la même carte sans contact (1), un second élément (28) de même forme que ledit premier élément;

- assembler lesdits premier et second éléments (28,29) de façon que le module électronique (6) soit incorporé entre lesdits éléments et protégés par eux.

**Patentansprüche**

1. Elektronikbaustein (6), geeignet für die Herstellung von tragbaren Objekten wie kontaktlose Karten (1) und/oder kontaktlose Elektroniketiketts, mit einem Trägersubstrat (10) für die Aufnahme einer elektronischen Mikroschaltung (7), wobei die besagte elektronische Mikroschaltung (7) an eine Antenne (2) angeschlossen werden soll, um einen kontaktlosen Betrieb des Bausteins (6) zu ermöglichen, wobei die Antenne (2) gänzlich auf dem Baustein enthalten ist und auf der Ebene des Trägersubstrats (10) angeordnete Windungen aufweist, wobei die Mikroschaltung (7) auf der gleichen Seite wie die Antenne (2) angeordnet ist, dadurch gekennzeichnet, dass die Mikroschaltung (7) rittlings auf den Windungen der Antenne (2) sitzt, wobei die Anschlussklemmen (11, 12) der Antenne über leitende Drähte (15) mit Kontaktstiften (13, 14) verbunden sind, die jeweils dem Baustein (6) oder der elektronischen Mikroschaltung (7) entsprechen, und wobei ein Isolator (16) zwischen der Mikroschaltung (7) und zumindest der sich unter der Mikroschaltung befindlichen Zone der Antenne eingefügt ist.

2. Elektronikbaustein (6) nach Anspruch 1, dadurch gekennzeichnet, dass die besagte Antenne (2) aus einer Spirale mit Außenabmessungen von etwa 5 bis 15 mm, vorzugsweise von etwa 12 mm, besteht, deren Endklemmen (11, 12) mit Kontaktstiften (13, 14) der elektronischen Mikroschaltung (7) verbunden sind.

3. Elektronikbaustein (6) nach Anspruch 2, dadurch gekennzeichnet, dass die Antenne (2) aus einer leitenden Spirale mit etwa 6 bis etwa 50 Windungen besteht, wobei jede Windung eine Breite von etwa 50 bis 300 µm aufweist, während der Abstand zwischen zwei angrenzenden Windungen etwa 50 bis 200 µm beträgt.

4. Elektronikbaustein (6) nach Anspruch 3, dadurch gekennzeichnet, dass die besagte Spirale eine etwa kreisförmige Außenform mit einem Außendurchmesser von etwa 5 bis 15 mm und vorzugsweise von etwa 12 mm aufweist.

**5.** Elektronikbaustein (6) nach Anspruch 3, dadurch gekennzeichnet, dass die besagte Spirale eine etwa viereckige Außenform mit einer Außenseite von etwa 5 bis 15 mm und vorzugsweise von etwa 12 mm aufweist.

**6.** Elektronikbaustein (6) nach Anspruch 3, dadurch gekennzeichnet, dass die besagte Spirale eine etwa ovale Außenform mit einer größeren Abmessung von etwa 15 mm und einer kleineren Abmessung von etwa 5 mm aufweist.

**7.** Elektronikbaustein (6) nach einem der vorherigen Ansprüche, dadurch gekennzeichnet, dass ein Abstimmkondensator (17) parallel zu den Klemmen (11, 12) der Antenne an die Kontaktstifte (13, 14) der elektronischen Mikroschaltung (7) angeschlossen ist, wobei der Wert des Kondensators (17) so gewählt wird, dass man eine Betriebsfrequenz des Bausteins (6) in einem Bereich von etwa 1 MHz bis 450 MHz erhält.

**8.** Elektronikbaustein (6) nach Anspruch 7, dadurch gekennzeichnet, dass der Abstimmkondensator (17) einen Wert von etwa 12 bis 180 Picofarad hat und dass die Betriebsfrequenz des Bausteins etwa 13,56 MHz beträgt.

**9.** Elektronikbaustein (6) nach Anspruch 7, dadurch gekennzeichnet, dass der Abstimmkondensator (17) einen Wert von etwa 30 bis 500 Picofarad hat und dass die Betriebsfrequenz des Bausteins etwa 8,2 MHz beträgt.

**10.** Elektronikbaustein nach einem der Ansprüche 7 bis 9, dadurch gekennzeichnet, dass der Abstimmkondensator (17) durch Auftragen von oxidiertem Silizium auf die zuvor mit einem Isolator (16) beschichtete Oberfläche der Mikroschaltung (7) erhalten wird.

**11.** Elektronikbaustein (6) nach einem der vorherigen Ansprüche, dadurch gekennzeichnet, dass er auf einer Seite des Trägers (10) eine an der Mikroschaltung (7) angeschlossene Antenne (2) und auf der anderen Seite des Trägers (10) sichtbare und ebenfalls an der Mikroschaltung (7) angeschlossene Kontakte umfasst, um eine Hybrid-Karte zu erhalten, die über die Kontakte (26) und/oder die Antenne (2) gelesen und geschrieben werden kann.

**12.** Elektroniketikett, das insbesondere für die Identifizierung von Objekten bestimmt ist, dadurch gekennzeichnet, dass es einen Elektronikbaustein (6) nach einem der Ansprüche 1 bis 11 aufweist.

**13.** Elektroniketikett nach Anspruch 12, dadurch gekennzeichnet, dass die größte Abmessung des Elektronikbausteins (6) etwa 5 bis 15 mm beträgt.

**14.** Elektroniketikett nach einem der Ansprüche 12 oder 13, dadurch gekennzeichnet, dass der mit seiner Mikroschaltung (7) und mit seiner Antenne (2) versehene Elektronikbaustein (6) auf einem Träger befestigt oder in einen Träger integriert ist, so dass das Etikett ein Stück mit einem zu identifizierenden Objekt bildet.

**15.** Herstellungsverfahren eines Elektroniketiketts, dadurch gekennzeichnet, dass es aus folgenden Etappen besteht:

- Ausstanzen aus einer kontaktlosen Karte (1) eines ersten Elements (29), das einen Elektronikbaustein (6) nach einem der Ansprüche 1 bis 11 enthält, gemäss einer gegebenen Stanzform, so dass um den Baustein herum noch Werkstoff verbleibt;
- Ausstanzen aus einer Karte, vorzugsweise aus der gleichen kontaktlosen Karte (1), eines zweiten Elements (28) der gleichen Form wie die des besagten ersten Elements;
- Zusammensetzen des besagten ersten und zweiten Elements (28, 29), so dass der Elektronikbaustein zwischen den besagten Elementen eingefügt und von ihnen geschützt wird.

**Claims**

**1.** An electronic module (6) of the type suitable for manufacturing portable objects such as contactless cards (1) and/or contactless electronic labels, and having a supporting substrate (10) intended to receive an electronic microcircuit (7), the said electronic microcircuit (7) intended to be connected to an antenna (2) so as to allow contactless functioning of the module (6), the antenna (2) being entirely contained on the module and having turns produced on the plane of the supporting substrate (10), the microcircuit (7) being disposed on the same side as the antenna (2), characterised in that the microcircuit (7) is disposed straddling the turns of the antenna (2), the connection terminals (11, 12) of the antenna being connected to respective corresponding contact pads (13, 14) on the module (6) or electronic microcircuit (7) by means of conductive wires (15), and an insulant (16) being interposed between the microcircuit (7) and at least the area of the antenna under the microcircuit.

**2.** An electronic module (6) according to Claim 1, characterised in that the said antenna (2) consists of a spiral with outside dimensions of around 5 to 15 mm, and preferably around 12 mm, whose end terminals (11, 12) are connected to contact pads (13, 14) on the electronic microcircuit (7).

3. An electronic module (6) according to Claim 2, characterised in that the antenna (2) consists of a conductive spiral having between approximately 6 and approximately 50 turns, each turn having a width of around 50 to 300 µm, the spacing between two contiguous turns being around 50 to 200 µm.

4. An electronic module (6) according to Claim 3, characterised in that the said turn has a substantially circular external shape, with an outside diameter of around 5 to 15 mm and preferably around 12 mm.

5. An electronic module (6) according to Claim 3, characterised in that the said spiral has a substantially square external shape, with outside dimensions of around 5 to 15 mm, and preferably approximately 12 mm.

6. An electronic module (6) according to Claim 3, characterised in that the said spiral has a substantially oval external shape, having a larger dimension of around 15 mm, and a smaller dimension of around 5 mm.

7. An electronic module (6) according to any one of the preceding claims, characterised in that a tuning capacitor (7) is connected in parallel to the terminals (11, 12) of the antenna to the contact pads (13, 14) of the electronic microcircuit (7), the value of the capacitor (17) being chosen so as to obtain an operating frequency of the module (6) situated within a range of around 1 MHz to 450 MHz.

8. An electronic module (6) according to Claim 7, characterised in that the tuning capacitor (17) has a value of around 12 to 180 picofarads, and in that the operating frequency of the module is approximately 13.56 MHz.

9. An electronic module (6) according to Claim 7, characterised in that the tuning capacitor (17) has a value of around 30 to 500 picofarads, and in that the operating frequency of the module is approximately 8.2 MHz.

10. An electronic module (6) according to any one of Claims 7 to 9, characterised in that the tuning capacitor (17) is obtained by depositing oxidised silicon on the surface of the microcircuit (7), previously coated with an insulant (16).

11. An electronic module (6) according to any one of the preceding claims, characterised in that it has, on one face of the support (10), an antenna (2) connected to the microcircuit (7) and, on the other face of the support (10), visible contacts (26) also connected to the microcircuit (7), so as to obtain a hybrid card which can be read and written to by means of the contacts (26) and/or the antenna (2).

12. An electronic label, notably intended for identifying objects, characterised in that it is provided with an electronic module (6) according to any one of Claims 1 to 11.

13. An electronic label according to Claim 12, characterised in that the larger dimension of the electronic module (6) is around 5 to 15 mm.

14. An electronic label according to one of Claims 12 or 13, characterised in that the electronic module (6), provided with its microcircuit (7) and its antenna (2), is fixed to or integrated on a support, so that the label can be made integral with an object to be identified.

15. A method of manufacturing an electronic label, characterised in that it includes the steps consisting in:

- cutting, from a contactless card (1), a first element (29) incorporating an electronic module (6) according to any one of Claims 1 to 11, according to a given cutout shape so as to leave material around the module;
- cutting, from a card, preferably from the same contactless card (1), a second element (28) with the same shape as the said first element;
- assembling the said first and second elements (28, 29) so that the electronic module (6) is incorporated between the said elements and protected by them.

FIG.1

FIG.2

FIG.3

fig.4A

fig.4B

fig.4C

fig.4D

FIG.4E

FIG.4F

FIG.4G

FIG.5

11   23 12   2 10

   7   15

fig.5A

16

fig.5B

fig.5C

25  7  10

7   2

fig.5D

FIG. 6A

FIG. 6B

FIG.7